# EUROPÄISCHE PATENTANMELDUNG

(11) **EP 2 130 636 A1**
(43) Veröffentlichungstag der Anmeldung: **09.12.2009**
(21) Anmeldenummer: 09006633.3
(22) Anmeldetag: 16.05.2009
(51) Int. Cl.: B23K 15/10

(54) **Druckstufensystem für eine Vorrichtung zum Elektronenstrahlschweißen und Verfahren zum Elektronenstrahlschweißen**

(30) Priorität: 07.06.2008 DE 102008027322
(71) Anmelder: Forschungszentrum Jülich GmbH, 52425 Jülich (DE)
(72) Erfinder: Behr, Wilfried, 53879 Euskirchen (DE)

(57) **Zusammenfassung**

Die Erfindung betrifft ein Druckstufensystem für eine Vorrichtung zum Elektronenstrahlschweißen eines Werkstücks in Bereichen größer als 10⁻⁴ mbar, wobei das Druckstufensystem mindestens zwei kaskadierende Stufen umfasst. Das Druckstufensystem weist Mittel, insbesondere eine Lokalvakuumkammer, auf, welche geeignet sind, eine Fügezone eines zu verbindenden Werkstücks gegenüber der Umgebung abzudichten, so dass an der Fügezone ein Vakuum erzeugt werden kann.

Ein Verfahren zum Elektronenstrahlschweißen dicker Werkstücke ist offenbart.

## Beschreibung

Die Erfindung betrifft ein Druckstufensystem für eine Vorrichtung zum Elektronenstrahlschweißen und ein Verfahren zum Elektronenstrahlschweißen.

Die Energieerzeugung der Zukunft wird voraussichtlich vom Ausbau der Nutzung regenerativer Energien geprägt sein. Hierzu gehören die Windkraft und besonders der Bau großer Offshore-Windkraftanlagen. Großprojekte in diesem Bereich werden fügetechnische Lösungen zur Herstellung der Anlagen erfordern, die Blechdicken von mehr als 10 mm zuverlässig und effizient verbinden. Es sind Windräder mit Masthöhen von etwa 100 m bei Mastdurchmessern von bis zu 10 m und Wanddicken der Rohrbauteile von bis zu 90 Millimeter, gegebenenfalls sogar noch mehr, geplant. Die Herstellung solcher Anlagen erfordert hocheffiziente Fügetechniken, da enorme Schweißnahtlängen bei großer Wanddicke anfallen werden. Bei der hohen Anzahl geplanter und bereits beschlossener Windenergieparks werden mehrere Tausend Windkraftanlagen erforderlich sein, die alle mit großformatigen Gründungsstrukturen installiert werden sollen.

Stand der Technik beim Schweißen dickwandiger Bleche von mehr als 20 Millimeter ist das mehrlagige Unterpulver- oder Schutzgasschweißen. Das mehrlagige Schweißen mit Lichtbogenschweißverfahren ist im Vergleich hierzu zeitaufwändig, da nur geringe Schweißvorschubgeschwindigkeiten und Einschweißtiefen erreicht werden. Durch relativ große Schweißbäder wird sehr viel Energie in die Bauteile eingebracht. Hierdurch ergibt sich nachteilig für dieses Verfahren ein hohes Spannungs- und Verzugspotential.

Erste Ansätze mit Laserstrahl und Laserstrahl-Hybridverfahren (Kombination aus Laser und Lichtbogenprozess) arbeiten in Bereichen von bis zu 30 mm Wanddicke. Diese Verfahren zeigen Potential, befinden sich aber noch im Laborstadium.

Eine Elektronenstrahlschweißanlage setzt sich aus drei Hauptkomponenten zusammen: Strahlerzeugung, Strahlführung und -formung und Arbeitskammer. Diese Komponenten sind in der Regel vakuumtechnisch voneinander getrennt.

Beim Elektronenstrahlschweißen wird die benötigte Energie von durch Hochspannung (60-300 kV) beschleunigten Elektronen in eine Prozesszone am Werkstück eingebracht. Mit zunehmender Beschleunigungsspannung steigen die erzielbare Nahttiefe sowie das Tiefe/Breiteverhältnis der Nahtgeometrie an.

Die Strahlerzeugung im Strahlerzeugerraum erfolgt immer im Vakuum, im einfachsten Fall mittels einer Anordnung aus Kathode und Anode. Die Kathode liefert durch Emission frei bewegliche Elektronen. Zu diesem Zweck wird an die Kathode eine negative Spannung angelegt, die Beschleunigungsspannung, und räumlich gegenüber der Elektronenwolke eine Anode auf Erdpotential angeordnet. Die aus dem Stand der Technik bekannten Steuerelektroden, Wehneltzylinder, Fokussiereinrichtungen, Manipulatoren, Pumpsysteme und elektrischen Versorgungen ergänzen den Strahlerzeuger bis hin zu einer fertigen Schweißanlage.

Beim Aufprall der Elektronen auf das Werkstück setzen diese einen Großteil ihrer kinetischen Energie in Wärme um. Vorteilhaft bietet das Elektronenstrahlschweißen dabei eine etwa gleich große Leistungsflussdichte wie das Laserstrahlschweißen bei gleichzeitig deutlich höherem Wirkungsgrad (Laser: 3-25 %, Elektronenstrahl: ca. 70 %).

Grundsätzlich wird zwischen dem Elektronenstrahlschweißen an Atmosphäre (NV-EBW) und im Vakuum (VEBW) unterschieden.

Aus DE 199 04 948 C2 ist eine Elektronenstrahlschweißanlage mit einem speziellen Druckstufensystem für einen Strahlerzeuger bekannt. Dieses entlässt den in einem Generatorvakuum erzeugten Elektronenstrahl zum Schweißen schwer zugänglicher Fügestellen des Werkstücks über ein mehrstufiges System koaxial zueinander angeordneter Druckstufen an die Atmosphäre (NV-EBW).

Elektronenstrahlschweißanlagen zum Schweißen an Atmosphäre (NV-EBW) verwenden keine Vakuumkammer für das Verschweißen des Werkstücks. Vielmehr wird dieses an Atmosphärendruck geschweißt. Beim NV-EBW wird im Vergleich zum Vakuumelektronenstrahlschweißen (VEBW) die Arbeitsvakuumkammer, in welcher sich das Werkstück befindet, durch ein Druckstufensystem ersetzt. Das Druckstufensystem ist in der Regel ein vom Strahlerzeuger bzw. Generator unabhängiges und rotationssymmetrisches System, welches schnell an der Unterseite des Generators gewechselt werden kann. Die Evakuierzeit für eine Vakuumarbeitskammer entfällt hierdurch, da das Druckstufensystem und die Generatorsäule ständig unter Vakuum gehalten werden. Es können hiermit auch großformatige Bleche miteinander verschweißt werden. Der Elektronenstrahl wird beim NV-EBW vom Hochvakuum des Strahlerzeugerraums über das Feinvakuum und das Grobvakuum des Druckstufensystems und sodann an die Atmosphäre zum Werkstück geführt. Im Kern des Druckstufensystems wird der Feinvakuum-bereich im unteren Teil der Generatorsäule bis zur inneren Düsenspitze verlängert. Diese ist so ausgebildet, dass sie als Druckdrossel zwischen dem Fein- und dem Grobvakuum der äußeren Düsenspitze dient. Um den Kern schließt sich in der Regel rotationssymmetrisch das Grobvakuum an und wird bis zur äußeren Austrittsöffnung geführt. Sodann wird der Strahl für den Schweißvorgang an die Atmosphäre an das Werkstück entlassen. Infolge der Kollision der Elektronen mit den Partikeln der Atmosphäre wird der Strahl mit wachsendem Arbeitsabstand von Düse zu Werkstück zunehmend breiter. Bei dem empfohlenen Abstand ist die Energiedichte des Strahls dennoch hoch genug, um einen Tiefschweißeffekt von bis zu 25 Millimeter Blechdicke zu erzielen.

Anlagenbedingt wird beim Vakuumelektronenstrahlschweißen durch Umfokussieren ein großer Arbeitsabstand von etwa 100 bis 2000 Millimeter zwischen Austrittsöffnung aus der Elektronenstrahlanlage und der Werkstückoberkante realisiert, während beim Elektronenstrahlschweißen an Atmosphäre Höhendifferenzen entlang der Schweißnaht durch ein Verschieben der Generatorsäule oder des Werkstücks ausgeglichen werden. Nur das Vakuumelektronenstrahlschweißen mit dem Werkstück im Hoch- oder Feinvakuum ermöglicht einen gebündelten Elektronenstrahl über einen großen Arbeitsabstand hinweg und somit das Schweißen von Blechdicken von mehr als 25 Millimeter Dicke.

Mit NV-EBW-Anlagen können im Gegenzug beliebig große Werkstücke verschweißt werden. Die erzielbare Nahttiefe ist verfahrensbedingt aber auf etwa maximal 25 mm beschränkt. Vorrichtungen zum Elektronenstrahlschweißen, welche auf NV-EBW-Systemen beruhen, sind somit nachteilig ungeeignet für dicke Werkstücke.

Der Schweißvorgang selbst kann in einem Hoch- oder Feinvakuum von etwa 10⁻⁴ bis 10⁻² mbar ausgeführt werden. Der Vorteil des Vakuumelektronenstrahlschweißens liegt in einem großen Blechdickenbereich von bis zu 300 Millimetern, sehr schmalen Nähten, einer geringen Gesamtwärmeeinbringung in das Werkstück (geringer Verzug) und hohen Schweißgeschwindigkeiten.

Vorteile des Elektronenstrahlschweißens an Atmosphäre sind hingegen die Verbindung beliebig großer Werkstücke, eine vergleichsweise sehr hohe Schweißgeschwindigkeit, gute Spaltüberbrückbarkeit und geringe bis keine Reflektionsprobleme bei der Energieeinkopplung in das Werkstück.

Nachteile des Vakuumelektronenstrahlschweißens sind die Strahlablenkung durch Magnetfelder, die Entstehung von Röntgenstrahlung, und die Limitierung der Werkstückgröße durch die Vakuumkammer. Nachteile des Elektronenstrahlschweißens an Atmosphäre sind begrenzte Blechdicken und ein geringer Arbeitsabstand, was zu einer Begrenzung der Lebensdauer der Vorrichtung bzw. der Elektronenstrahlkanone auf Grund von Hitzeentwicklung und Strahlung führen kann, selbst wenn Abschirmungen vorgenommen werden.

Das Werkstück kann auf einem X/Y-Tisch oder mit Hilfe eines Roboters unter dem Strahl bewegt werden. Je nach Schweißaufgabe und -Anlage kann auch der Generator verfahren werden.

Das herausragende Merkmal des Elektronenstrahlschweißens ist die hohe Energiedichte von bis zu 10⁷ W cm⁻². Sie ermöglicht schmale und tiefe Schweißnähte sowie ein weitgehend verzugsarmes Schweißen. Das Werkstück befindet sich zu diesem Zweck üblicherweise in einer Arbeitsvakuumkammer in einem Vakuum von etwa 10⁻⁴ mbar, damit der Elektronenstrahl auch über die Distanz von mehreren 100 mm gebündelt bleibt. Der Brennfleckdurchmesser des Strahles beträgt etwa 0,1 bis 1 Millimeter.

Für die Eingangs genannten Anwendungen muss die Arbeitskammer für das Werkstück zur Aufrechterhaltung des nötigen Vakuums beim Vakuumelektronenstrahlschweißen übergroß dimensioniert sein, damit die erforderlichen Blechdicken und -größen miteinander verschweißt werden können. Üblicherweise betragen die Volumina der Vakuumkammern bis zu etwa 50 m³. Große Vakuumkammern weisen ein Volumen von mehr als 200 m³ auf.

Die Anforderungen für die oben genannten Anwendungen erfordern aber nachteilig weit größere Kammervolumina, in denen sowohl der Elektronenstrahlerzeuger als auch die Bleche gleichzeitig angeordnet sind, da letztere aus heutiger Sicht überdimensioniert sind. Auch entsprechend große und teure Pumpsysteme müssen zur Erzeugung des Hochvakuums bereitgestellt werden. Es sind zu diesem Zweck Vakuumkammern mit einem Volumen von bis zu 2000 m³ und mehr geplant. Die Kosten für derartige Elektronenstrahlschweißanlagen sind nicht zuletzt wegen der notwendigen Pumpsysteme als immens zu bezeichnen.

Ungeeignet für den oben genannten Zweck des Schweißens dicker und großer Bleche sind hingegen Lokalvakuumsysteme. Bei diesen bekannten Systemen erfolgt das Schweißen in einer kleinen, auf den Schweißbereich begrenzten Vakuumkammer, die sich entlang der Schweißnaht mobil bewegen lässt. Nachteilig treten auf Grund der Bewegung verfahrensbedingt sowie auf Grund der Vorrichtungen selbst hohe Leckageraten auf, so dass nachteilig Bleche mit Dicken von mehr als 25-30 Millimeter nicht verbindbar sind.

Aufgabe der Erfindung ist es, eine Vorrichtung zum Elektronenstrahlschweißen bereit zu stellen, mit der beliebig lange Werkstücke mit bis zu 100 Millimeter Dicke und mehr, flexibel, das heißt in einem Arbeitsvorgang miteinander verbunden werden können. Eine weitere Aufgabe der Erfindung ist es, ein entsprechendes Verfahren zum Schweißen beliebig langer Werkstücke mit bis zu 100 Millimeter Dicke und mehr bereit zu stellen.

Die Aufgabe wird durch ein Druckstufensystem nach Anspruch 1 und durch ein Verfahren gemäß Nebenanspruch gelöst. Vorteilhafte Ausgestaltungen ergeben sich aus den darauf rückbezogenen Ansprüchen.

Erfindungsgemäß ist ein Druckstufensystem für eine Vorrichtung zum Elektronenstrahlschweißen in Druckbereichen größer als 10⁻⁴ mbar vorgesehen. Das Druckstufensystem umfasst mindestens zwei kaskadierende Stufen. Das Druckstufensystem weist Mittel auf, die geeignet sind, eine Fügezone eines zu verbindenden Werkstücks gegenüber der Umgebung abzudichten, so dass an der Fügezone ein Vakuum erzeugt werden kann. Das Vakuum ist ausreichend niedrig, um den Tiefschweißeffekt, den das Druckstufensystem erzeugt, zu erhöhen. Das Vakuum wird zu diesem Zweck in Abhängigkeit von dem verwendetem Material und dessen Stärke erzeugt.

Im Rahmen der Erfindung wurde erkannt, dass die bisher lediglich für das NV-EBW verwendeten Druckstufensysteme der Lehrmeinung entgegen auch beim Schweißen dicker Bleche mit mehr als 25 mm Stärke genutzt werden können, sofern an der Fügezone ein Vakuum anliegt. Es sind alle Druckstufensysteme, wie aus dem Stand der Technik zum Elektronenstrahlschweißen an Atmosphäre bekannt, verwendbar.

Bevorzugt umfasst das Druckstufensystem zur Abdichtung der Fügezone gegenüber der Umgebung eine Lokalvakuumkammer. Die Lokalvakuumkammer weist an ihrem unteren Ende eine Anpressfläche an das Werkstück auf, so dass es die Fügezone einschließt. Dadurch wird die Fügezone gegenüber der Außenatmosphäre der Umgebung abgedichtet, so dass ein Vakuum an der Fügezone erzeugt werden kann. Die Lokalvakuumkammer ist insbesondere an der Außenwand des Druckstufensystems angeordnet und umgibt dessen Austrittsdüse für den Elektronenstrahl vorzugsweise rotationssymmetrisch.

Im Rahmen der Erfindung wurde ferner erkannt, dass durch eine Kombination eines an sich bekannten Druckstufensystems zum Elektronenstrahlschweißen an Atmosphäre (NonVacuum-ElectronBeamWelding: NV-EBW) mit einer Lokalvakuumkammer als Mittel, unter welcher sich das Werkstück befindet, bewirkt wird, dass die Leistungsfähigkeit des Elektronenstrahls an der Fügezone überproportional verbessert wird. Dadurch werden Werkstücke mit Dicken von weit mehr als 25 Millimetern, insbesondere mit mehr als 30 mm Dicke, flexibel, das heißt in einem Arbeitsgang, verschweißt. Das Schweißen erfolgt dann vorteilhaft unter einer kleinen, auf den Schweißbereich begrenzten Vakuumkammer. Die Vakuumkammer und das Werkstück bewegen sich hierzu relativ zueinander.

Im Rahmen der Erfindung wurde weiterhin erkannt, dass mittels dieser Kombination zweier Maßnahmen aus Druckstufensystem und Lokalvakuumkammer, welche aus dem Stand der Technik als solche für das Verschweißen dicker Werkstücke von mehr als 30 Millimeter bekanntermaßen jeweils als ungeeignet anerkannt sind, die Aufgabe der Erfindung gelöst wird.

Ein Elektronenstrahlgenerator mit einem Druckstufensystem, wie für NV-EBW-Anlagen bekannt, in Kombination mit einer Lokalvakuumkammer als Mittel zum Abdichten der Fügezone gegenüber der Umgebung, bewirkt, dass vorteilhaft ein Tiefschweißeffekt auf mobiler Basis bereit gestellt wird. Es können großformatige, dicke Werkstücke mit mehr als 30 Millimeter Dicke bis hin zu 100 Millimeter Dicke verschweißt werden. Es ist sogar denkbar, dass mit dem erfindungsgemäßen Druckstufensystem noch dickere Werkstücke miteinander verbindbar sind.

Der Elektronenstrahl wird im Elektronenstrahlgenerator in einer an sich bekannten Weise zunächst in einem Hochvakuum von etwa 10⁻⁴ mbar erzeugt und sodann über ein Fokussiersystem in ein Feinvakuum des Druckstufensystems von etwa höchstens 10⁻² mbar oder weniger geleitet. Der Elektronenstrahl wird sodann in das Grobvakuum des Druckstufensystems mit einem Druckbereich von etwa 1 mbar oder weniger geleitet. Erst im Anschluss an diese Vorgehensweise wird der Elektronenstrahl in das Vakuum an der Prozesszone an das Werkstück, das heißt vorzugsweise in eine Lokalvakuumkammer als Mittel zum Abdichten der Fügezone gegenüber der Umgebung geleitet. Der Elektronenstrahl wird daher fortlaufend in Areale höheren Drucks bis zur Fügezone geleitet, ohne dabei allerdings an Atmosphärendruck zu gelangen.

Die Fügezone des zu verbindenden Werkstücks ist während des Elektronenstrahlschweißens im Vakuum der Lokalvakuumkammer und unterhalb des Druckstufensystems angeordnet. Das Druckstufensystem kann zu diesem Zweck an den Strahlerzeuger ebenfalls mittels eines Bajonettverschlusses angekoppelt sein.

Das Druckstufensystem umfasst vorzugsweise die an der Außenwand eines ersten Druckrohrs angeordnete Lokalvakuumkammer als Abdichtmittel für die Fügezone. Die Lokalvakuumkammer vermeidet die bekannten Nachteile des Vakuumschweißens in überdimensionierten Arbeitskammern mit teuren Pumpsystemen. Das erfindungsgemäße Druckstufensystem erzeugt eine jeweils im Vergleich zum Elektronenstrahlschweißen an Atmosphäre und zum Lokalvakuumschweißen deutliche und überraschend überproportional höhere Energiedichte am Schweißpunkt des Werkstücks und Tiefschweißeffekte, wie sie bisher nur aus Vakuumschweißanlagen bekannt sind, das heißt mit besonders tiefen Schweißnähten bei gleichzeitig niedrigem Verzug des Werkstücks. Darüber hinaus wird mit einer Lokalvakuumkammer zum Abdichten der Fügezone gegenüber der Umgebung in besonders vorteilhafter Weise ein mobiles also bewegbares System zum Elektronenstrahlschweißen bereitgestellt. Die Kombination aus einer Lokalvakuumkammer, die an dem Druckstufensystem aus dem Bereich des Elektronenstrahlschweißens an Atmosphäre angeordnet ist, stellt sicher, dass trotz der Leckageraten an der Fügezone ein Strahlschweißbetrieb mit Tiefschweißeffekt im Sinne eines ,echten Vakuumschweißvorgangs' auch bei dicken Blechen biss zu 100 Millimeter sichergestellt ist.

Durch das erfindungsgemäße Druckstufensystem wird das erforderliche Druckgefälle und die Abschirmung der Fügezone gegenüber Umgebungsdruck gewährleistet. Hierdurch erst wird Elektronenstrahlschweißen wie in einer Vakuumkammer für Vakuumelektronenstrahlschweißen ermöglicht, da auf der vergleichsweise kurzen Distanz zwischen Druckstufensystem und Oberkante des Werkstücks nur geringe Leistungsdichteverluste auch bei Drücken > 10⁻² mbar an der Fügezone verursacht werden. Während der Ausführung des Verfahrens kann daher der Arbeitsabstand der äußeren Düse zur Fügezone auf mehr als 20 und sogar 30 Millimeter festgelegt werden.

In einer Ausgestaltung der Erfindung weisen das Druckstufensystem und die Lokalvakuumkammer auch Mittel zur Ausbildung eines Bajonettverschlusses auf, mit dem die Lokalvakuumkammer schnell an die Außenwand des Druckstufensystems angekoppelt werden kann. Hierdurch wird ein schnelles Wechseln der Lokalvakuumkammer und eine Anpassung der Geometrie der Lokalvakuumkammer an die des Werkstücks ermöglicht. Als eine weitere Möglichkeit der Verbindung der Lokalvakuumkammer an das Druckstufensystem ist diese hieran angeflanscht.

Das Gesamtvolumen der Lokalvakuumkammer beträgt in einer weiteren vorteilhaften Ausgestaltung der Erfindung weniger als 5 Liter, und insbesondere weniger als 1 bis 2 Liter. Vorteilhaft ist auf diese Weise gewährleistet, dass das Volumen und das Gewicht der Lokalvakuumkammer gering sind.

Als besonders vorteilhaft hat sich eine Lokalvakuumkammer mit einer Kaskadenanordnung, das heißt mit wenigstens zwei, vorzugsweise drei oder vier Einzelkammern erwiesen. Die Kammern werden durch Trennwände der Lokalvakuumkammer gebildet, welche die einzelnen Kammern auch in vakuumtechnischer Hinsicht voneinander trennen. Vorzugsweise bildet dabei die Innenwand der innersten Kammer zusammen mit der Außenwand des Druckstufensystems einen Bajonettverschluss aus, so dass die Lokalvakuumkammer als solches mit dem Druckstufensystem schnell und sicher verbunden und auch schnell gegen eine andere Lokalvakuumkammer mit verschiedenem Volumen oder anderer Form ausgetauscht werden kann. Das Kaskadensystem der Lokalvakuumkammer bewirkt besonders vorteilhaft, dass die Energiedichte des Strahls hoch ist und unerwünschte Leckagen der Lokalvakuumkammer weiter reduziert werden. Der Elektronenstrahl wird dadurch besser auf die Prozesszone gebündelt.

Die Lokalvakuumkammer kann in einer weiteren Ausgestaltung der Erfindung an seiner zum Werkstück gerichteten Fläche, der Anpressfläche an das Werkstück, Abdichtmittel zur Abdichtung der Fügezone des Werkstücks gegenüber der Außenatmosphäre aufweisen. Hierzu können insbesondere Bürsten oder auch expandierbare Dichtmittel oder Dichtlippen aus Metall- und / oder Karbonfasern vorgesehen sein.

Vorzugsweise erlaubt eine Kombination aus Federelement und Bürstendichtung besonders vorteilhaft die Sicherstellung des erforderlichen Mindestvakuums an der Schweißstelle. Das oder die Federelemente drücken die Dichtlippe(n) mit Bürstendichtung(en) an die Bauteiloberfläche, so dass diese gegenüber der Umgebung abgedichtet wird, und das notwendige Vakuum an der Fügezone erzeugt wird.

Die Lokalvakuumkammer weist vorteilhaft an den Einzelkammern Einlässe bzw. geeignete Stutzen auf, die es ermöglichen, Pumpen oder Kompressoren anzuschließen, um die Einzelkammern zu evakuieren, so dass an der Fügezone des Werkstücks das Vakuum erzeugt werden kann.

Absaugpumpen dienen unmittelbar der Erzeugung des Vakuums in der oder den Einzelkammern der Lokalvakuumkammer und sind an den entsprechenden Absaugstutzen der Kammern angeordnet.

Alternativ hierzu kann in einer weiteren besonders vorteilhaften Ausgestaltung der Erfindung das Vakuum in der Lokalvakuumkammer über das Venturi-Prinzip erzeugt werden. Fließt durch eine äußerste Kammer der Lokalvakuumkammer ein gasförmiges Medium, z. B. Luft, welche durch einen Kompressor erzeugt wurde, so ist an der engsten Stelle des Rohres der dynamische Druck, bzw. Staudruck maximal und der statische Druck bzw. Ruhedruck minimal. Die Geschwindigkeit des fließenden Gases steigt im Verhältnis der Querschnitte beim Durchströmen des eingeschnürten Teils an, weil überall dieselbe Menge durchfließt. Gleichzeitig sinkt der Druck an der Innenseite des Strömungsaustritts. Damit entsteht in einer inneren Kammer der Lokalvakuumkammer, unterhalb welcher das zu verschweißende Werkstück angeordnet ist, ein Unterdruck, welcher für den Schweißvorgang genutzt werden kann. Druckluft wird zu diesem Zweck in die die Fügezone umgebende äußere Vakuumkammer über einen Einlass hineingepumpt. Der entstehende Unterdruck in der innersten Kammer ist ausreichend niedrig, um eine hohe Energiedichte des Elektronenstrahls ohne Aufweitung des Elektronenstrahls und damit einen Tiefschweißeffekt größer als 25 Millimeter zu gewährleisten.

Das Venturi-Prinzip bewirkt besonders vorteilhaft, dass auf teuere Pumpanlagen zur Erzeugung des Vakuums zumindest in der äußersten Kammer der Lokalvakuumkammer der Vorrichtung verzichtet werden kann. Ein Kompressor zur Erzeugung von Druckluft, Druckzuleitungen, Verbindungsmittel zum Einleiten der Druckluft in einen Einlassstutzen, sind zu diesem Zweck zumindest an der äußeren Kammer der Lokalvakuumkammer angeordnet. Die Lokalvakuumkammer selbst ist nach dem Venturi-Prinzip aufgebaut, so dass sie ein Durchströmen mit Druckluft mit Ausbildung des Venturi-Prinzips ermöglicht. Eine innere Kammer kann aber selbstverständlich zur Aufrechterhaltung eines gewünschten Unterdrucks an der Fügezone zusätzlich mit einer Pumpe evakuiert werden.

In einer weiteren Ausgestaltung der Erfindung sind Druckstufen in Form eines ersten Druckrohres und eines koaxial innerhalb des ersten Druckrohres angeordneten zweiten Druckrohres ausgebildet, wobei das Druckstufensystem ein Verhältnis der Länge zum Durchmesser von mehr als 4:1 bei einem Durchmesser von nicht größer als 80 mm aufweisen kann.

Es ist aber ohne Einschränkung der Erfindung möglich, ein anderes Druckstufensystem aus dem Stand der Technik, welches zum Elektronenstrahlschweißen an Atmosphäre (NV-EBW) bekannt ist, zu verwenden, beispielsweise ein Druckstufensystem mit einem Verhältnis der Länge zum Durchmesser von mehr als 4:1 bei einem Durchmesser von größer als 80 mm.

Vorteilhaft ist die äußere Form des Druckstufensystems im Wesentlichen rotationssymmetrisch ausgebildet. Die Spitze der Ausgangsdruckstufe weist im Wesentlichen die Form eines Kegels oder Kegelstumpfes auf. Auch die innen liegenden Bauteile des Druckstufensystems können im Wesentlichen rotationssymmetrisch ausgebildet sein. Innerhalb des Druckstufensystems sind Druck-, Kühlmittel-und/oder Arbeitsgasleitungen ausgebildet.

Eine Lokalvakuumkammer als Mittel zum Abdichten an dem Druckstufensystem weist vorzugsweise dieselbe Rotationssymmetrie wie das Druckstufensystem selbst auf.

Das Druckstufensystem kann aus einer die ersten Enden des ersten Druckrohrs und des zweiten Druckrohrs verbindenden Grundplatte, die an einen Strahlerzeuger ankoppelbar ist, einem die zweiten Enden des ersten Druckrohrs und des zweiten Druckrohrs verbindenden Druckstufenhalter, einer in dem Druckstufenhalter koaxial aufgenommenen ersten Düse, einem an dem Druckstufenhalter koaxial aufgenommenen Düsenkegel, einem an dem Druckstufenhalter koaxial aufgenommenen, den Düsenkegel umschließenden Deckkegel und einer zwischen der Spitze des Düsenkegels und der Spitze des Deckkegels angeordneten zweiten Düse, bestehen. Ein derartiges Druckstufensystem ist aus der DE 199 04 948 C2 bekannt, deren Inhalt durch Bezugnahme in die vorliegende Patentanmeldung aufgenommen wird.

Das Druckstufensystem umfasst, wie erwähnt, mindestens zwei kaskadierende Stufen. Eine weitere Verbesserung kann durch eine zusätzliche, das System umgebende Heliumüberdruckkammer erzielt werden. Selbiges gilt auch für die Lokalvakuumkammer, deren äußerste Kammer ebenfalls als Heliumüberdruckkammer ausgebildet sein kann.

Ein Verfahren zum Elektronenstrahlschweißen eines Werkstücks umfasst die Schritte:
- an die Fügezone eines zu verbindenden Werkstücks wird ein Druckstufensystem mit Mitteln, welche geeignet sind, die Fügezone gegenüber der Umgebung abzudichten, angeordnet,
- Herstellen eines Vakuums an der Fügezone,
- Herstellen eines Vakuums in den Druckstufen des Druckstufensystems,
- Erzeugen eines Elektronenstrahls im Elektronenstrahlgenerator im Hochvakuum,
- Überführen des Strahls über die Druckstufen in das Vakuum an der Fuge,
- Verbinden des Werkstücks durch Bewegen der Austrittsdüse des Druckstufensystems bzw. des Elektronenstrahls relativ zur Fuge des Werkstücks.

Abweichungen von dieser Reihenfolge sind selbstverständlich möglich.

Vorzugsweise wird ein Druckstufensystem mit einer Lokalvakuumkammer als Mittel an der Fügezone angeordnet und ein Vakuum an der Fuge in der Lokalvakuumkammer erzeugt.

Es kann vorteilhaft ein Druckstufensystem mit einer Lokalvakuumkammer als Mittel an der Fügezone derartig angeordnet werden, dass das Vakuum an der Fuge in der Lokalvakuumkammer erzeugt werden kann.

Während des Verfahrens wird der Elektronenstrahl fortlaufend in Areale höheren Drucks bis zur Fügezone geleitet, ohne dabei allerdings an Atmosphärendruck zu gelangen.

Die Kombination von jeweils zwei zur Erzeugung eines Tiefschweißeffekts in einem Werkstück von mehr als 25 bzw. 30 Millimetern Dicke ungeeigneten Maßnahmen, nämlich dem Druckstufensystem und der Lokalvakuumkammer, löst die Aufgabe der Erfindung. Die Beschleunigungsspannung liegt hierfür vorzugsweise in einem Bereich von etwa 150 bis 175 kV.

Das Verfahren sieht vorteilhaft vor, die Lokalvakuumkammer aus mindestens zwei Einzelkammern mittels des Venturi-Prinzips zu evakuieren.

Der Abstand zwischen der äußeren Düse des Druckstufensystems und der zu verbindenden Fuge, der Arbeitsabstand, kann besonders vorteilhaft auf etwa 20 Millimeter, insbesondere mehr als 25 Millimeter eingestellt werden. Üblicherweise beträgt der Abstand zwischen der Düse eines NV-EBW-Druckstufensystems und der Fuge nicht mehr als 15 Millimeter. Wie erwähnt, wurden Druckstufensysteme bisher immer für Atmosphärenschweißen verwendet. Für diese Anwendung ist es unerlässlich, den genannten Abstand von maximal 15 Millimetern von der Düse des Druckstufensystems zur Fuge nicht zu überschreiten, da ansonsten an Atmosphäre die nötigen Schweißtiefen von bis zu 25 Millimeter nicht mehr erreicht werden können. Wie erwähnt, betrugen die Schweißtiefen im Stand der Technik bei NV-EBW mit Druckstufensystemen dennoch nicht mehr als etwa 25 Millimeter bei gleichzeitig geringer Lebensdauer auf Grund von Hitzeentwicklung und Strahlung.

Mit der vorgenannten erfindungsgemäßen Vorrichtung und dem erfindungsgemäßen Verfahren ist es möglich, die Schweißtiefen und gleichzeitig die Lebensdauer des Druckstufensystems mit zunehmendem Abstand der Düse von der Fuge zu erhöhen.

Die Lokalvakuumkammer als Mittel zum Abdichten der Fügezone kann zur Aufrechterhaltung der Arbeitsatmosphäre an der Prozesszone entweder durch Pumpen oder, wie erwähnt, mittels des Venturi-Prinzips evakuiert werden und /oder mit Helium als Schutzgas geflutet werden.

Für das Verfahren wird im Falle eines Mehrkammersystems als Lokalvakuumkammer die die Fuge des Werkstücks unmittelbar umgebende Einzelkammer der Lokalvakuumkammer mit dem niedrigsten Druck ausgestattet.

Es ist selbstverständlich, dass im Sinne der Erfindung die verwendete Bezeichnung "Verschweißen eines Werkstücks" sich nicht nur auf ein Werkstück als solches, sondern auch auf mehrere Werkstücke beziehen kann, sofern diese miteinander verschweißt werden sollen.

Im Weiteren wird die Erfindung an Hand einiger Ausführungsbeispiele und der beigefügten Figuren näher erläutert.
- Fig. 1:: Druckstufensystem gemäß Stand der Technik.
- Fig. 2:: Schematische Querschnittsansicht einer erfindungsgemäßen Vorrichtung zum Elektronenstrahlschweißen.

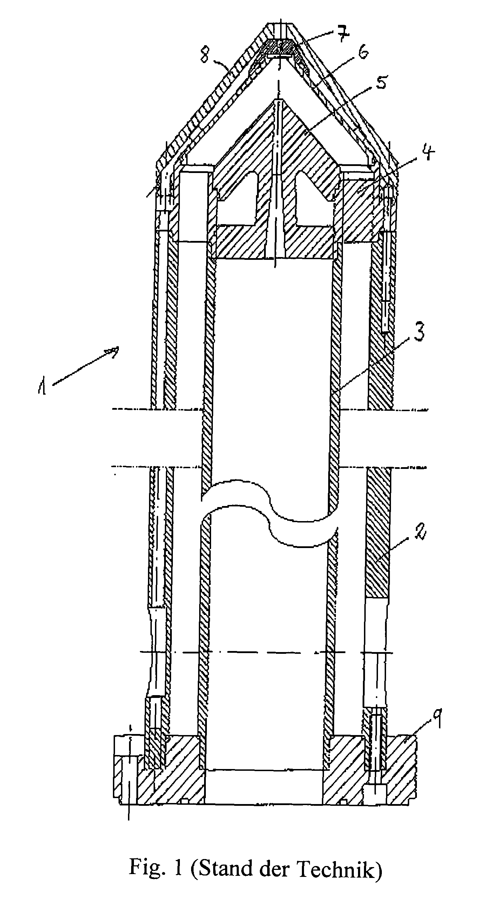

Fig. 1 zeigt einen Schnitt durch ein Druckstufensystem gemäß der DE 199 04 948 C2, welches wie nachfolgend beschrieben adaptiert wurde.

Wie aus der Figur ersichtlich, besteht das Druckstufensystem 1 aus folgenden Bauteilen: Einem ersten Druckrohr 2, einem koaxial innerhalb des ersten Druckrohres 2 angeordneten zweiten Druckrohr 3, einem Druckstufenhalter 4, einer ersten Düse 5, einem Düsenkegel 6, einer zweiten Düse 7, einem Deckkegel 8 und einer Grundplatte 9, deren Aufbau und Funktion im Folgenden beschrieben werden.

Nach der vakuumtechnischen Abschätzung der Absaugquerschnitte im Grob- und Feinvakuum-Bereich und der Berechnung der Effektivsaugleistung am Rezipienten muss bei der Auslegung der ersten und zweiten Druckstufe 2 und 3 auf die Besonderheiten der vorhandenen Elektronenstrahlanlage eingegangen werden. Dabei sollten die Druckstufen jeweils aus einer Düsenaufnahme und einer Düse selbst bestehen. Für beide Druckstufen gelten gemeinsam folgende Anforderungen:
- rotationssymmetrische Geometrie,
- Sicherstellen ausreichender Kühlung,
- Trennung der gegenüberliegenden Druckbereiche,
- leichte Auswechselbarkeit der Druckdüsen,
- strömungsgünstige Geometrie zwischen innerer und äußerer Druckstufe.

### Erstes Druckrohr 2 / erste Druckstufe:

Das Druckrohr 2 dient als Stütz- bzw. Tragkörper des Druckstufensystems 1 und der Zentrierung der weiteren Komponenten. Es weist die erforderliche Anbindung von Wasser-, Arbeitsgas- und Vakuumzuführungen auf.
Gleichzeitig bildet es eine Abschirmung des Grobvakuum-Bereiches innerhalb des Druckrohres 2 gegen die Atmosphäre außerhalb des Druckrohres 2.
Neben der mechanischen Belastbarkeit des zu wählenden Materials der Außenhülle muss beachtet werden, dass es korrosionsbeständig und nicht magnetisierbar ist, da magnetisierbare Werkstoffe zu unkontrollierten Strahlablenkungen im Druckstufensystem führen und es so zerstören. Ebenso sollte es kostengünstig und leicht zu beschaffen sein. Da dieses Bauteil der Strahlenergie nicht direkt ausgesetzt ist, sind seine Wärme leitenden Eigenschaften zweitrangig.

Aus der Innenbohrung des ersten Druckrohres 2 folgt der Querschnitt der Grobvakuumabsaugung für die weitere Auslegung des Druckstufensystems.
Die Konstruktion der Grobvakuum-Druckstufe orientiert sich stark an der vorliegenden Form der äußeren Abdeckung. Dabei kann vorteilhaft die Austrittsöffnung der äußeren Druckdüse 7 aus schweißtechnischer Sicht nah an die Fügestelle herangeführt werden. Um dies zu erreichen ist es notwendig, eine effektive Kühlung der in Schweißbadnähe liegenden Bauteile zu gestalten. Ebenso muss die äußere Düse 7 ausreichend gekühlt werden, da zu erwarten ist, dass sie durch die Strahlaufweitung des Elektronenstrahls stark erwärmt wird. Aus diesem Grund wurde für die Abdichtung der Düse gegen Kühlwasser und Vakuum eine Graphitfolie von 0,2 mm Stärke gewählt, die sich durch einfaches Stanzen mittels Locheisen in die gewünschte Form bringen lässt. Die Graphitfolie ist bis 400°C temperaturbeständig und kann darüber hinaus Form- und Lagetoleranzen in Axialrichtung durch Anpassen ihrer Stärke ausgleichen. Um den vakuumtechnischen Anforderungen Rechnung zu tragen, wurde auf eine separate Befestigung des äußeren Düsenkegels 6 sowie der dazu gehörenden Düse 7 verzichtet.
Beide Teile werden durch die Abdeckung in ihren Sitz gepresst. Die Abdichtung am Fuß der äußeren Druckstufe erfolgt durch einen O-Ring. Eine entsprechende Nut ist auf dem Umfang des Düsenkegels 6 einzubringen. Dadurch wird eine ausreichende Abdichtung des Grobvakuum-Bereiches gegen den Kühlwasser-Bereich erzielt. Um die Kühlleistung des Kühlwasserstromes effektiv zu nutzen, wird der gesamte Raum zwischen Düsenkegel 6 und Abdeckung 8 geflutet. Dadurch wird die größtmögliche Kühlung erzielt und gleichzeitig kann auf zusätzliche Kühlmittelbohrungen verzichtet werden, die ansonsten für eine Kühlmittelzufuhr zur äußeren Druckdüse 7 nötig wären. Besonders an der äußeren Druckstufe zeigt sich, dass die gewählte Kegelform nicht nur vakuumtechnische, sondern auch mechanische Vorteile bietet. Trotz der geringen Wandstärke der Vorvakuumdruckstufe kann in axialer Richtung eine sehr hohe Montagekraft ohne Gefahr des Verzugs aufgenommen werden. Dies ist besonders wichtig, da nur durch die Vorspannkraft in der Spitze des Druckstufensystems 1 die Dichtwirkung sichergestellt wird. Aus mechanischen Gründen wurde als Material für den äußeren Düsenkegel 6 CrNi-Stahl gewählt. Aufgrund der guten Abschirmung des Systems durch den Kühlwasserstrom ist auch hier die schlechte Wärmeleitung des gewählten Materials zu vernachlässigen. Als Material für die äußere Druckdüse 7 wird Kupfer gewählt, da es den größten Wärmeleitkoeffizienten der zu Verfügung stehenden Materialien besitzt.

### Zweites Druckrohr 3 / zweite Druckstufe:

Das koaxial innerhalb des ersten Druckrohres 2 liegende zweite Druckrohr 3 übernimmt die Trennung von Grobvakuum-Bereich (zwischen erstem Druckrohr 2 und zweitem Druckrohr 3) und Feinvakuum-Bereich (innerhalb des zweiten Druckrohres 3).
Die Abdichtung der Anschlussstellen erfolgt ergänzend zu den Übergangspassungen, die einen sehr hohen Durchlasswiderstand aufweisen, mit zusätzlichen
O-Ringen. Um einen sicheren Zusammenbau des Druckstufensystems zu gewährleisten, wird das innere Druckrohr 1/10 mm kürzer gefertigt als es das Nennmaß zuließe, um eine Überbestimmung und damit einhergehende Undichtigkeit zu vermeiden. Der Durchmesser des inneren Druckrohres ergibt sich aus den vakuumtechnischen Notwendigkeiten. Der Außendurchmesser darf nicht zu groß werden, da sonst der Querschnitt für die Absaugung der Vorvakuumstufe verringert wird. Der Innendurchmesser muss jedoch so groß wie möglich gewählt werden, um das Feinvakuum bis zur ersten Düse 5 zu erhalten. Es ist also ein Kompromiss zu finden, der sowohl die geometrischen Erfordernisse der Vorvakuumdruckstufe als auch der Feinvakuumstufe in ausreichender Weise berücksichtigt. Durch die Wahl des äußeren Durchmessers des zweiten Druckrohres 3 ergibt sich der Absaugquerschnitt der Vorvakuumseite. Die Wandstärke (hier 3 mm) für das innere Druckrohr ist nötig, um die Verbindungsstellen spanend bearbeiten zu können und die entsprechenden Passungen einzubringen. Es ist weiter darauf zu achten, dass der Absaugquerschnitt der Vorvakuumstufe ausreichend groß ist, damit es nicht zu einer Verblockung (Strömungsgeschwindigkeit > Schallgeschwindigkeit) im Absaugquerschnitt kommt. Dies ist bei den hier gewählten Dimensionen nicht der Fall.
Für die Auslegung der inneren Druckstufe sind aufgrund der vorangegangenen Konstruktionen bereits eine Vielzahl von Randbedingungen festgelegt. Die Düse der inneren Druckstufe muss folgende Bedingungen erfüllen:
- Anbindung einer Kühlwasserbohrung mit einem Durchmesser von dᵢ = 6 Millimeter,
- Ausblendung des zu erwartenden Randstrahls durch gleichzeitige Funktion als Aperturblende,
- koaxiale Position zum Elektronenstrahl.

Die Distanz zwischen der inneren und der äußeren Druckdüse 5 und 7 sollte so kurz wie möglich sein, da der Elektronenstrahl sich im Bereich des Grobvakuums bereits aufweitet. Gleichzeitig darf aber der Abstand zwischen beiden Druckstufen nicht zu gering werden, da sonst die Gefahr besteht, dass der Absaugquerschnitt für den Grobvakuum-Bereich zu sehr eingeschnürt wird. Die gewählte Düsengeometrie basiert auf Untersuchungen verschiedener Düsenanordnungen und Strahlfiihrungsprinzipien, die bereits Anfang der 70er Jahre gemacht wurden [Arata, Y.: Some fundamental properties of nonvacuum electron beam. Plasma, Electron and laser beam technology, American society for metals, 1986, pp. 71-90]. Dabei wurde ein Plasmafokussierungseffekt beschrieben, der sich bei der Wahl eines Strahlführungskanals mit engem Querschnitt bemerkbar macht. Es kommt durch die Ionisation der Restatmosphäre zu einer Einschnürung des Elektronenstrahls. Um diesen Effekt zu nutzen, wurde die innere Druckstufe so konzipiert, dass sie sowohl den zu erwartenden Randstrahl ausblenden als auch die Düsenfunktion übernehmen kann. Die Funktion der Strahlausblendung wird von dem unteren Teil der Druckstufe erfüllt, in den eine Kegelbohrung mit einer Steigung von 10:1 eingebracht wird. Diese Kegelbohrung wird über ihre gesamte Länge gekühlt. Durch diese Ausblendung des Elektronenstrahls auf einer Länge von 20 mm wird verhindert, dass der Randstrahl seine Energie konzentriert abgibt und die Druckstufe zerstört. Die dann folgende zylindrische Bohrung mit einem Maximaldurchmesser von 2 mm erfüllt die Funktion des Plasmakanals. Die Düse wird direkt durch die Wasserzuführung im Druckstufenhalter gekühlt.

### Druckstufenhalter 4, Grundplatte 9:

Das erste Druckrohr 2 und das zweite Druckrohr 3 sind an ihrem einen Ende mittels der Grundplatte 9 verbunden, die auch als Schnittstelle für den jeweils eingesetzten Strahlerzeuger dient und also an dessen Geometrie anzupassen ist. Die anderen Enden des ersten Druckrohres 2 und des zweiten Druckrohres 3 sind mittels des Druckstufenhalters 4 verbunden.
Diesem Bauteil kommt eine zentrale Bedeutung zu und es muss eine Vielzahl von Funktionen übernehmen:
- Zentrierung der Bauteile zueinander,
- Sicherstellen der Koaxialität des Druckstufensystems,
- Verteilen der Medien Wasser, Arbeitsgas und Vakuum,
- Abdichtung des Fein- und Grobvakuum-Bereiches,
- Aufnahme der Druckstufen,
- Verbinden der Druckrohre zu einer Montageeinheit,
- Ermöglichen eines einfachen und schnellen Düsenwechsels.

Die Geometrie des Druckstufenhalters 4 orientiert sich am einzuhaltenden Außendurchmesser von hier 80 mm. Er stellt die Verbindung zwischen erstem Druckrohr 2 und Abdeckung 8 her, so dass er alle Durchführungen und erforderlichen Dichtungen aufnehmen muss. Darüber hinaus muss der Kühlwasserstrom für die innere Düse 5 unterverteilt werden. Die Aufnahme der Druckstufen sollte einfach, aber vakuum- bzw. wasserdicht erfolgen. Der Saugvolumenstrom des Grobvakuums soll möglichst ungestört bis zur äußeren Düse 7 herangeführt werden. Schließlich muss die Abdeckung 8 am Druckstufenhalter 4 zu befestigen sein. Da sich im Druckstufenhalter 4 sehr kleine Gewindebohrungen befinden und er eine hohe Stabilität aufweisen muss, wurde als Werkstoff CrNi-Stahl gewählt. Er ist antimagnetisch und korrosionsbeständig und bietet hohe Stabilität. Seine niedrige Wärmeleitfähigkeit ist hier von untergeordneter Bedeutung. Die Aufnahme der Druckstufen erfolgt selbstklemmend durch Schiebesitze wobei die Position zusätzlich durch die Pressung der O-Ringe gesichert ist. Im Betrieb können die Druckstufen sich nicht lösen, da sie durch den Unterdruck in ihrer jeweiligen Stellung fixiert werden. Im gefluteten Zustand ist so ohne spezielle Werkzeuge ein schnelles und einfaches Wechseln der Düsen möglich. Die Befestigung am ersten Druckrohr 2 erfolgt durch vier Messingschrauben M3 x 15. Dabei wird gleichzeitig das innere (zweite) Druckrohr 3 positioniert und gegenüber dem Grobvakuum-Bereich abgedichtet. Da bei diesem Bauteil eine Vielzahl von Positionieraufgaben in einer Montage erfolgt, kommt es auch hier wieder sehr auf die genaue Einhaltung der Toleranzangaben an. Die lagerichtige Positionierung der Bauteile erstes Druckrohr 2, Druckstufenhalter 4 und Abdeckung 8 zueinander erfolgt mittels eines 3 mm Zylinderstiftes, der in einer entsprechenden Bohrung aller drei Bauteile sitzen muss. So wird vor allem sichergestellt, dass die O-Ringe der Wasser- und Gasdurchführungen auf ihren Dichtflächen anliegen.

### Abdeckung 8

Um die Prämisse der Rotationssymmetrie und gleichmäßiger Zugänglichkeit der Fügestellen zu erfüllen, wurde der Kopf des Druckstufensystems 1 als Kegel ausgeführt. Dabei sollte ein Kegelwinkel von max. 90° eingehalten werden. Größere Winkel wären bei der Gestaltung der Absaugung nützlich, würden aber das Erreichen von Kehlnähten an zu fügenden Bauteilen stark einschränken. Mit einem Kegelwinkel bis 90° lassen sich Kehlnähte unter einem Kehlnahtwinkel größer oder gleich 90° mit einem günstigen Anstellwinkel von 45° und bis zum minimalen Arbeitsabstand hin bearbeiten. Ein Kegelkopf dieser Geometrie lässt aber unter Berücksichtigung des nötigen Absaugquerschnittes keine zusätzlichen innenliegenden Zuführungen für Wasser und Arbeitsgas zu. Deshalb wurde eine Zufuhr des Arbeitsgases innerhalb des Kegelmantels gewählt. Versuche mit bereits bestehenden Druckstufensystemen haben gezeigt, dass man entweder eine Helium geflutete Überdruckstufe vor die Strahlaustrittsdüse installieren oder den Gasstrom koaxial zuführen sollte. Dadurch erreicht man eine Schutzgasatmosphäre an der Fügestelle und saugt überwiegend Helium in das Druckstufensystem hinein. Zusätzlich verringert sich die Strahlaufweitung. Für die konstruktive Auslegung der äußeren Abdeckung bedeutet dies, dass der Heliumgasstrom bis zur Strahlaustrittsstelle geführt wird, um die verschiedenen Arbeitsgasfunktionen zu erfüllen. Dabei kann der Gasstrom sowohl als so genannter Cross-Blow querströmen als auch zum Teil in einer Überdruckstufe münden. Man erreicht so einen minimalen Aufwand bei der Gaszufuhr und den maximalen Nutzen bei der Gasanwendung. Neben der Arbeitsgaszufuhr muss die äußere Abdeckung 8 des Druckstufensystems 1 noch folgende Funktionen übernehmen:
- Kühlung der äußeren Düse 7 des Druckstufensystems 1,
- Abschirmung des Druckstufensystems 1 gegen äußere Einflüsse.

Der Außendurchmesser der Abdeckung 8 wird entsprechend des ersten Druckrohres 2 mit 80 mm festgelegt. Da zur Abdichtung der verschiedenen Medien (Kühlwasser, Arbeitsgas) und Vakuum Dichtelemente nötig sind, und da auch die Arbeitsgaszufuhr in der Wand der Abdeckung 8 erfolgen soll, kann seine Wandstärke nicht beliebig klein gewählt werden. Unter Berücksichtigung der erforderlichen Nuten und Bohrungen wurde bei einem Außendurchmesser von 80 mm ein Innendurchmesser von 68 mm gewählt. Die Weiterleitung von Wasser und Arbeitsgas innerhalb der Abdeckung erfordert die Einbringung verschiedener Bohrungen bzw. Nuten. Bei der Fertigung dieses wie auch aller anderen Teile des Druckstufensystems 1 ist besonders auf die Einhaltung der Koaxialität zu achten.

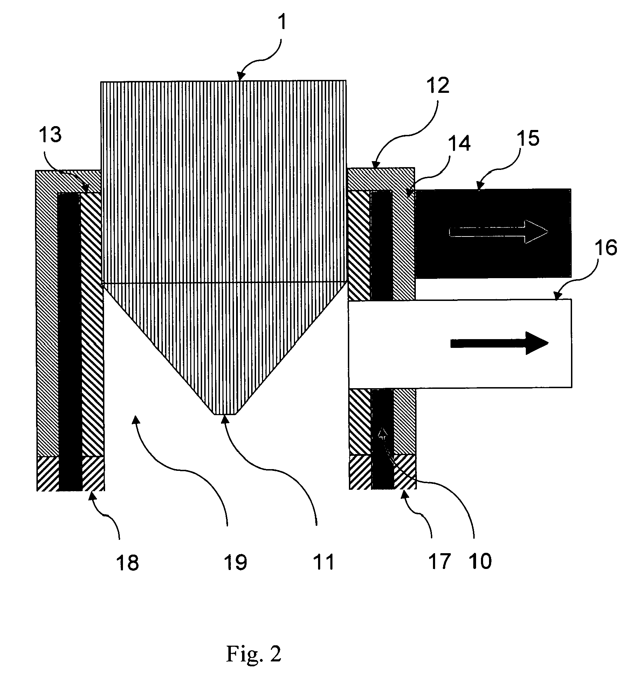

Fig. 2 zeigt schematisch die Anbindung einer Lokalvakuumkammer als Mittel zum Abdichten der Fügezone gegenüber der Umgebung an dieses Druckstufensystem 1.

Das Druckstufensystem 1 aus der Fig. 2 ist längs schraffiert und weitestgehend identisch zu dem Druckstufensystem 1 in der Fig. 1. Das Druckstufensystem 1 für eine Vorrichtung zum Elektronenstrahlschweißen in Druckbereichen von größer als 10⁻⁴ mbar umfasst ebenfalls die beiden kaskadierenden Stufen. Die Druckstufen sind in Form des ersten Druckrohres und des koaxial innerhalb des ersten Druckrohres angeordneten zweiten Druckrohres wie in Fig. 1 ausbildet. Das Druckstufensystem 1 weist ein Verhältnis von Länge zu Durchmesser von mehr als 4 zu 1 bei einem Außendurchmesser von 81 Millimetern auf. Das System 1 ist in seiner äußeren und inneren Form im Wesentlichen rotationssymmetrisch ausgebildet. Die Spitzen der beiden Ausgangsdruckstufen weisen die Form eines Kegels oder eines Kegelstumpfes auf. In Fig. 2 ist diesbezüglich lediglich der äußere Kegelstumpf 11 dargestellt. Dieser bildet die Austrittsöffnung in Form einer Düse für den Elektronenstrahl. Wie hierzu in der DE 199 04 948 C2 beschrieben, sind im Innern Druck-, Kühlmittel- und/oder Arbeitsgasleitungen angeordnet, welche auf Grund der schematischen Darstellung nicht dargestellt sind. Das Druckstufensystem 1 ist mittels einer wie in Fig. 1 gezeigten Grundplatte 9 an einen Strahlerzeuger (nicht dargestellt) ankoppelbar. Der Elektronenstrahl wird demgemäß im Hochvakuum des Strahlerzeugers erzeugt und von dort über ein zweites Druckrohr 3 mit Feinvakuum in das Grobvakuum eines ersten Druckrohrs 2 des Druckstufensystems 1 überfiihrt, s. die Ausführungen zu Fig. 1. Der Druck während des Schweißvorgangs beträgt in dem zweiten Druckrohr 3 etwa 10⁻³ mbar und der Druck in dem ersten Druckrohr 2 beträgt etwa 10⁻¹ mbar. Entsprechende Pumpen zur Erzeugung und Aufrechterhaltung des Fein- und Grobvakuums in dem Druckstufensystem 1 sind an die beiden Druckstufen anschließbar. Die Leistung des Elektronenstrahls beträgt bis zu 20 kW bei etwa 150 kV Beschleunigungsspannung.

Die Lokalvakuumkammer 12, 13, 14 ist mittels eines Bajonettverschlusses, welcher durch geeignete Mittel an der Außenwand des Druckstufensystems 1 sowie der Wand 13 der Lokalvakuumkammer gebildet wird, befestigt. Dargestellt ist ein Zweikammersystem als Lokalvakuumkammer. Die erste Kammer 10 wird zwischen der Außenwand 14 und der Innenwand 13 der Lokalvakuumkammer gebildet. Die zweite Kammer 19 wird innerhalb der Innenwand 13 gebildet. Beide Wände weisen einen rotationssymmetrischen Querschnitt wie das Druckstufensystem 1 auf.

Die Lokalvakuumkammer bzw. ihre beiden Einzelkammern weisen etwa folgende Abmessungen auf. Der Außendurchmesser der Lokalvakuumkammer an Wand 14 beträgt etwa 150 Millimeter bei einer Gesamtlänge von etwa 300 Millimetern. Das Material besteht aus einem nichtmagnetisierbaren Werkstoff, hier vorzugsweise aus Aluminium. Das Volumen der inneren Kammer 19 beträgt etwa 1 l. Das Volumen der äußeren Kammer 10 beträgt maximal 0,5 1. Beide Kammern 19 und 10 werden über die Pumpen 15, 16, dargestellt durch die Pfeile, evakuiert, bis ein Druck von etwa maximal 1 mbar in der Kammer 19 bzw. maximal ein Druck von etwa 10 mbar in der Kammer 10 vorherrscht. Da der Druck im Grobvakuum des Druckrohrs 2 (s. Fig. 1) vor Austritt aus der Düse 11 etwa nur 10⁻¹ mbar beträgt, ist gewährleistet, dass der Elektronenstrahl fortlaufend in Areale höheren Drucks geleitet wird, ohne allerdings an Atmosphärendruck zu gelangen. Atmosphärendruck führte nachteilig zu einer übermäßigen Aufweitung des Strahls bei Verlust des Tiefschweißeffekts oberhalb von 25 Millimetern Materialstärke.

Der Druck in der äußeren Kammer 10 wird daher gemäß des ersten Ausführungsbeispiels auf etwa 10 mbar begrenzt, so dass ein oder mehrere Werkstück(e) miteinander verschweißt werden kann bzw. können.

Die Lokalvakuumkammer weist am unteren Ende ihrer Wände 13, 14 jeweils Dichtmittel 17, 18 auf, welche in Fig. 2 schräg von rechts oben nach links unten schraffiert angedeutet sind. Als Dichtmittel sind in diesem Ausführungsbeispiel Dichtringe aus Stahl oder auch Karbonfaserbürsten geeignet. Auch ein expandierender Dichtring kann zu diesem Zweck vorgesehen sein.

In einer zweiten Ausführungsform der Erfindung ist an Stelle der genannten Pumpe 15 zur Evakuierung der äußeren Kammer 10 der Lokalvakuumkammer ein Kompressor über einen oberen Einlass der Außenwand 14 mit der Lokalvakuumkammer verbunden. Über den Kompressor wird Druckluft erzeugt und in die äußere Kammer 10 unter hohem Druck eingeführt. Am unteren Ende der äußeren Kammer 10 verlässt die Druckluft die äußere Kammer 10 wieder nach außen. Die Kammer 10 ist also derartig ausgeführt, dass über das Venturi-Prinzip am Übergang zur inneren Kammer 19 ein Unterdruck erzeugt wird. Die innere Kammer 19 wird zudem zusätzlich mittels einer Pumpe 16, wie in Fig. 2 gezeigt, evakuiert. Mittels des Venturi-Prinzips wird ein Druck von etwa 500 mbar in der äußeren Kammer 10 erzeugt, wohingegen der Druck in der inneren Kammer, also an der Fügezone nur etwa 10 mbar beträgt. Zur Ausbildung des Venturi-Prinzips ist die Außenwand 14 an ihrem unteren Ende als Drossel ausgeführt. Die Außenwand 14 ist hierzu geringfügig kürzer, am unteren Ende mit einer geeigneten Abschlusslippe versehen, so dass sie etwas höher angeordnet ist, als die Innenwand 13 der Lokalvakuumkammer. Dichtmittel sind entsprechend der Ausbildung des Venturi-Prinzips in dieser Ausführungsform nicht vorgesehen.

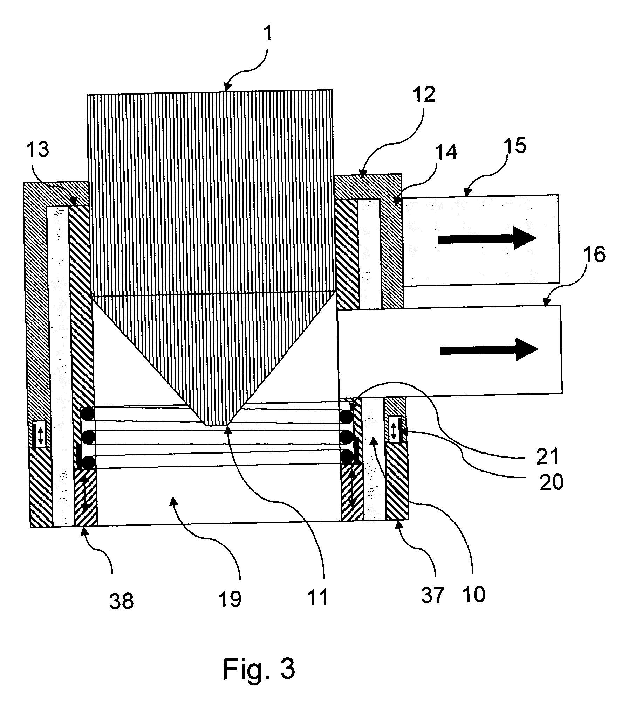

Figur 3 zeigt schematisch die Anbindung einer Lokalvakuumkammer als Mittel zum Abdichten der Fügezone gegenüber der Umgebung. Die Kammer ist wie die der Figur 2 aufgebaut, wobei gleiche Bezugszeichen identische Bauteile darstellen.
In Fig. 3 ist allerdings zusätzlich eine innere Dichtlippe 38 an die Wand 13 und eine äußere Dichtlippe 37 an die Wand 14 angebracht.
Die äußere und die innere Dichtlippe werden durch Federelemente, beispielhaft mit der Spiralfeder 21 und der Tellerfeder 20, an die Bauteiloberfläche angedrückt.
Hierdurch wird besonders vorteilhaft bewirkt, dass Bauteilunebenheiten, Positionier- und Bewegungsabweichungen ausgeglichen werden können. Zusätzlich ist eine geometrische Anpassung der Dichtlippenposition an die durch den Schweißprozess entstehende Schweißnahtraupe möglich.
Die Dichtlippen 37, 38 werden aus ringartigen elastischen und / oder bürstenartigen Halbzeugen, vorzugsweise aus Normteilen, hergestellt. Beispielsweise sind Bürstendichtungen aus Stahl und Kohlefaser möglich.
Die Kombination aus Federelement und Bürstendichtung, wie in Fig. 3 gezeigt, erlaubt ebenfalls besonders vorteilhaft die Sicherstellung des erforderlichen Mindestvakuums an der Schweißstelle. Das oder die Federelemente drücken dabei die Dichtlippe(n) mit Bürstendichtung(en) an die Bauteiloberfläche, so dass diese gegenüber der Umgebung abgedichtet wird, und das notwendige Vakuum an der Fügezone erzeugt wird.

Es kann ein beliebiges anderes aus dem Stand der Technik bekanntes Druckstufensystem für NV-EBW verwendet werden. Der erfindungsgemäße Gedanke manifestiert sich darin, ein an sich bekanntes Druckstufensystem aus dem Bereich des Elektronenstrahlschweißens an Atmosphäre (NV-EBW) mit einer Lokalvakuumkammer, wie in Fig. 2 - 3 gezeigt, zu kombinieren. Dadurch allein wird die Aufgabe der Erfindung bereits gelöst und hohe Schweißtiefen bei gleichzeitig flexiblem Schweißvorgang erzielt. Mit Flexibilität ist gemeint, dass mittels des Druckstufensystems auch unwegsame, sperrige Bauteile in einem Arbeitsgang miteinander verschweißt werden können.

Das Druckstufensystem einer beliebigen NV-EBW-Anlage kann auch mit einer großen Vakuumarbeitskammer für das Schweißstück kombiniert werden, wie sie für Hochvakuum- oder Feinvakuumanlagen bekannt ist, wenngleich dies im Sinne der Erfindung von untergeordneter Priorität ist. Dennoch ist es vorstellbar, ein derartig bekanntes NV-EBW Druckstufensystem auch mit einer Vakuumkammer großen Volumens, beispielsweise mit einem in 50 m³ Maßstab oder größer zu kombinieren.

Für die Anwendung des erfindungsgemäßen Druckstufensystems ist es prinzipiell unerheblich, ob ein Werkstück unter das Druckstufensystem hindurch bewegt wird, oder umgekehrt, also das Druckstufensystem über das Werkstück hinweg geführt wird. Bevorzugt ist die Bewegung des Werkstücks unterhalb des Druckstufensystems mit Lokalvakuumkammer.

Es versteht sich, dass die angegebenen Drücke der Einzelkammern der Lokalvakuumkammer nur beispielhaft zu verstehen sind. Welcher Druck in der Lokalvakuumkammer bzw. deren Einzelkammern exakt zu erzeugen ist / sind, hängt unter anderem von der Art des Werkstücks, also dessen Dicke, Material, Form sowie dem Vorschub und den Gegebenheiten des Strahlerzeugers ab. Wie gezeigt, ist der Begriff des Vakuums an der Fügezone als ein Unterdruck zu verstehen, welcher ausreichend niedrig ist, um den Tiefschweißeffekt des Druckstufensystems als solches so zu verstärken, dass auch dickere Bleche miteinander verschweißt werden können.

## Patentansprüche

1. Druckstufensystem (1) für eine Vorrichtung zum Elektronenstrahlschweißen in Druckbereichen größer als 10⁻⁴ mbar, wobei das Druckstufensystem mindestens zwei kaskadierende Stufen umfasst,
**dadurch gekennzeichnet,**
**dass** das Druckstufensystem (1) Mittel aufweist, welche geeignet sind, eine Fügezone eines zu verbindenden Werkstücks gegenüber der Umgebung abzudichten, so dass an der Fügezone ein Vakuum erzeugt werden kann.

2. Druckstufensystem (1) nach Anspruch 1,
bei dem das Mittel eine Lokalvakuumkammer (12, 13, 14) umfasst.

3. Druckstufensystem nach einem der vorhergehenden Ansprüche 1 oder 2, **gekennzeichnet durch**
ein Volumen der Lokalvakuumkammer von weniger als 5 Litern.

4. Druckstufensystem nach einem der vorhergehenden Ansprüche,
bei dem die Lokalvakuumkammer wenigstens zwei Einzelkammern (10, 19) aufweist.

5. Druckstufensystem nach Anspruch 4,
bei dem die Lokalvakuumkammer derartig ausgebildet ist, dass sie über das Venturi-Prinzip evakuierbar ist.

6. Druckstufensystem nach einem der vorhergehenden Ansprüche,
bei dem Pumpen und/oder Kompressoren zur Erzeugung des Vakuums an der Fügezone des zu verbindenden Werkstücks an dem Mittel angeschlossen werden können.

7. Druckstufensystem nach einem der vorherigen Ansprüche,
wobei dessen Druckstufen in Form eines ersten Druckrohres (2) und eines koaxial innerhalb des ersten Druckrohres (2) angeordneten zweiten Druckrohres (3) ausgebildet sind.

8. Druckstufensystem nach einem der vorherigen Ansprüche,
bei dem das Druckstufensystem ein Verhältnis der Länge zum Durchmesser von mehr als 4:1 bei einem Durchmesser von nicht größer als 80 mm aufweist.

9. Druckstufensystem nach einem der vorherigen Ansprüche 1 bis 7,
**dadurch gekennzeichnet,**
**dass** das Druckstufensystem ein Verhältnis der Länge zum Durchmesser von mehr als 4:1 bei einem Durchmesser von größer als 80 Millimetern aufweist.

10. Druckstufensystem nach einem der vorhergehenden Ansprüche 7 bis 9, bestehend aus einer die ersten Enden des ersten Druckrohrs (2) und des zweiten Druckrohrs (3) verbindenden Grundplatte (9), welche an einen Strahlerzeuger einer Vorrichtung zum Elektronenstrahlschweißen ankoppelbar ist;
einem die zweiten Enden des ersten Druckrohrs (2) und des zweiten Druckrohrs (3) verbindenden Druckstufenhalter (4);
einer in dem Druckstufenhalter (4) koaxial aufgenommenen ersten Düse (5); einem an dem Druckstufenhalter (4) koaxial aufgenommenen Düsenkegel (6);
einem an dem Druckstufenhalter (4) koaxial aufgenommenen, den Düsenkegel (6) umschließenden Deckkegel (8);
und einer zwischen der Spitze des Düsenkegels (6) und der Spitze des Deckkegels (8) angeordneten zweiten Düse (7).

11. Druckstufensystem nach einem der vorgenannten Ansprüche,
**gekennzeichnet durch**
mindestens eine Dichtlippe, insbesondere mit einer Bürstendichtung.

12. Druckstufensystem nach einem der vorgenannten Ansprüche, bei der Dichtmittel über Federelemente an die Bauteiloberfläche gedrückt werden.

13. Verfahren zum Elektronenstrahlschweißen eines Werkstücks, mit den Schritten:
- an die Fügezone eines zu verbindenden Werkstücks wird ein Druckstufensystem (1) mit Mitteln, welche geeignet sind, die Fügezone gegenüber der Umgebung abzudichten, angeordnet,
- Herstellen eines Vakuums an der Fügezone,
- Herstellen eines Vakuums in den Druckstufen des Druckstufensystems,
- Erzeugen eines Elektronenstrahls im Elektronenstrahlgenerator im Hochvakuum,
- Überführen des Strahls über die Druckstufen in das Vakuum an der Fuge,
- Verbinden des Werkstücks durch Bewegen der Austrittsdüse des Druckstufensystems bzw. des Elektronenstrahls relativ zur Fuge des Werkstücks.

14. Verfahren nach vorhergehendem Anspruch 13,
bei dem eine Lokalvakuumkammer als Mittel an der Fügezone angeordnet wird und das Vakuum an der Fuge in der Lokalvakuumkammer erzeugt wird.

15. Verfahren nach Anspruch 14,
bei dem zumindest einzelne Kammern der Lokalvakuumkammer zur Aufrechterhaltung der Arbeitsatmosphäre mittels des Venturi-Prinzips evakuiert werden.

16. Verfahren nach einem der vorhergehenden Ansprüche 13 bis 15,
**gekennzeichnet durch**
einen Arbeitsabstand der Düse des Druckstufensystems zur Fuge von mindestens 20 Millimetern.
